# EUROPEAN PATENT SPECIFICATION

(11) **EP 0 416 574 B1**
(45) Date of publication and mention of the grant of the patent: **01.03.1995**
(21) Application number: 90117064.7
(22) Date of filing: 05.09.1990
(51) Int. Cl.: H01L 29/788, H01L 29/41, H01L 27/115, G11C 17/00

(54) **E2PROM with a floating gate formed in a semiconductor substrate and method of fabricating the same**
E2PROM mit in einem Halbleitersubstrat geformten schwebenden Gate und Herstellungsverfahren
E2PROM avec grille flottante formée dans un substrat semi-conducteur et méthode pour sa fabrication

(30) Priority: 05.09.1989 JP 230110/89
(43) Date of publication of application: 13.03.1991
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Konno, Yoshikuni c/oIntellectual Property Division, 1-1 Shibaura 1-chome Minato-ku Tokyo105 (JP)
(74) Representative: Lehn, Werner, Dipl.-Ing.

(56) References cited:
- EP-A- 0 228 761
- US-A- 4 796 228
- PATENT ABSTRACTS OF JAPAN, vol. 9, no. 4 (E-288)[1727], 10th January 1985 ; & JP-A-59 154 071

## Description

The present invention relates to a semiconductor memory device and a method of fabricating the same, and is particularly suitable for use in memory cells of a flash electrically erasable and programmable read only memory (FE²PROM) having a floating gate, erase gate and control gate stacked at part thereof.

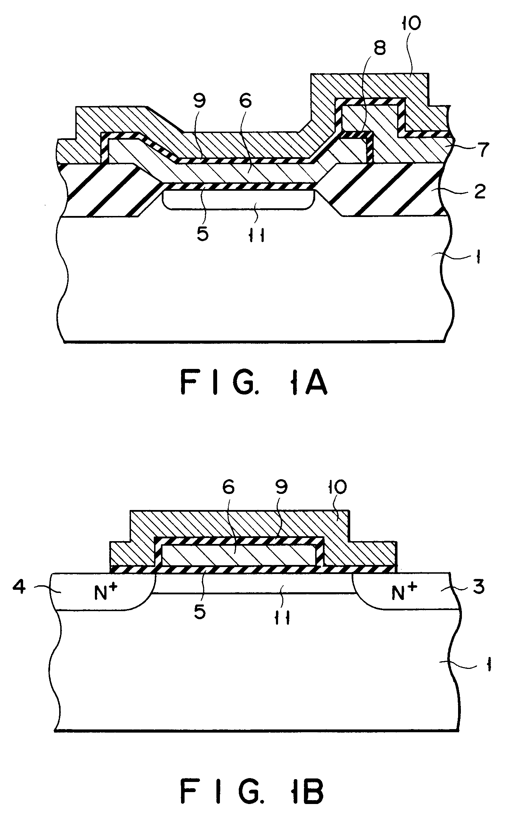

Memory cells of an FE²PROM are constituted as shown in, for example, Figs. 1A and 1B; similar devices are known from e.g. EP-A-0 228 761. Fig. 1B illustrates the cross section of a memory cell transistor along its channel direction, while Fig. 1A shows the cross section along a direction horizontal and normal to the channel direction. A field insulating film 2 is selectively formed on the major surface of a semiconductor substrate 1 made of P type silicon. This insulating film 2 serves to isolate elements in adjacent memory cells. N⁺ type source and drain regions 3 and 4 are formed away from each other at a given interval in an element region in the substrate 1. Boron ions (B⁺) or the like are implanted in a channel region in the substrate 1 between the source and drain regions 3 and 4 to thereby form a P type impurity diffusion region 11 for optimizing the impurity density of the channel region. A first gate insulating film 5 is formed on the substrate 1 between the source and drain regions 3 and 4. A floating gate 6 made of polysilicon is formed on this insulating film 5. An erase gate 7 made of polysilicon is formed on the field insulating film 2 and on an edge portion of the floating gate 6. A thin insulating film 8 lies between the erase gate 7 and the floating gate 6. A second gate insulating film 9 is formed on the surfaces of the floating gate 6 and erase gate 7. A control gate 10 made of polysilicon is formed on this insulating film 9.

An interlayer insulating film (not shown) is formed on the resultant structure. Contact holes are respectively formed in this interlayer insulating film on the source region 3 and drain region 4. Contact holes are also formed in part of the erase gate 7 and part of control gate 10. Metal wiring layers, such as a source wiring layer, drain wiring layer and each gate wiring layer, made of aluminum or the like, are formed in the contact holes and on the interlayer insulating film. A voltage for programming, a readout voltage and an erase voltage are selectively applied through these metal wiring layers to the source and drain regions 3 and 4 and individual gates 7 and 10 in accordance with the respective operation modes.

According to the above memory cell structure, however, a three-layered polysilicon layer (floating gate 6, erase gate 7 and control gate 10) is deposited on part of the field insulating film 2, thus increasing a difference in surface level of the interlayer insulating film in this partial region and another region and increasing the distance between the metal wiring layers and the major surface of the substrate 1. As a result, the metal wiring layers (source wiring layer, drain wiring layer) are easily cut at the corner portions of the contact holes for leading the source and drain.

If a layer of high melting point metal, such as molybdenum or tungsten, is formed on the control gate 10 to reduce the resistance of the gate 10, there is a large step between that portion of the gate 10 which lies on the erase gate 7 and that portion of the gate 10 which lies on the floating gate 6. As a result, the high melting point metal layer is easily cut.

Accordingly, it is the primary object of the present invention to provide a semiconductor memory device which can prevent metal wiring layers from being accidentally or undesirably cut and has an improved reliability.

It is another object of this invention to provide a method of fabricating a semiconductor memory device, which can reduce the step of an interlayer insulating film and facilitate processing of metal wiring layers.

The first object can be achieved by providing a semiconductor memory device comprising:
a semiconductor substrate of a first conductivity type;
a field insulating film selectively formed on a major surface of the semiconductor substrate;
a source region and a drain region of a second conductivity type, formed in an element region on a major surface region of the semiconductor substrate, separated from each other at a predetermined interval;
a groove formed in the major surface of the semiconductor substrate between the source region and the drain region;
a first insulating film formed on a surface of the semiconductor substrate at bottom and side wall portions of the groove;
a floating gate formed in the groove;
a thin second insulating film formed on part of a surface of the floating gate;
an erase gate formed on part of the second insulating film and part of the field insulating film;
a third insulating film formed on a surface of the erase gate and the other part of the floating gate; and
a control gate formed on the third insulating film.

With the above structure, as the floating gate is formed in the groove, the surface step of an interlayer insulating film becomes smaller, thus preventing metal wiring layers formed on this interlayer insulating film from being cut.

The second object of this invention can be achieved by providing a method of fabricating a semiconductor memory device, comprising the steps of:
selectively forming a field insulating film for element isolation on a major surface of a semiconductor substrate;
forming a groove in a device region on the major surface of the semiconductor substrate;
forming a first insulating film on bottom and side wall portions of the groove;
forming a floating gate in the groove;
forming a thin second insulating film on a surface of the floating gate;
forming an erase gate on the second insulating film on part of the floating gate and part of the field insulating film;
forming a third insulating film on a surface of the erase gate and the other part of the floating gate;
forming a control gate on the third insulating film; and
forming a source region and a drain region in a major surface region of the semiconductor substrate on both sides of the groove.

Since the above method can form the floating gate formed in the groove, it is possible to reduce the surface step of an interlayer insulating film and facilitate processing of metal wiring layers.

Accordingly, the semiconductor memory device can prevent metal wiring layers from being accidentally or undesirably cut and has an improved reliability and the method can reduce the step of the interlayer insulating film and facilitate processing of the metal wiring layers.

This invention can be more fully understood from the following detailed description when taken in conjunction with the accompanying drawings, in which:
Figs. 1A and 1B are cross-sectional views showing the structure of a memory cell of a conventional FE²PROM;
Fig. 2A is a plan view illustrating the pattern of memory cells of a semiconductor memory device according to the first embodiment of this invention;
Fig. 2B is a cross sectional view of the pattern in Fig. 2A taken along the line 2B-2B;
Fig. 2C is a cross sectional view of the pattern in Fig. 2A taken along the line 2C-2C;
Figs. 3A and 3B are cross sectional views for explaining memory cells of a semiconductor memory device according to the second embodiment of this invention;
Figs. 4A to 4E are cross sectional views illustrating the cross sections of the pattern in Fig. 2A taken along the line 2B-2B in the order of the fabrication steps, for explaining a method of fabricating the semiconductor memory device according to the first embodiment of the invention;
Figs. 5A to 5E are cross sectional views illustrating the cross sections of the pattern in Fig. 2A taken along the line 2C-2C in the order of the fabrication steps, for explaining the method of fabricating the semiconductor memory device according to the first embodiment of the invention; and
Fig. 6 is a cross sectional view for explaining a method of fabricating the semiconductor memory device according to the second embodiment of the invention.

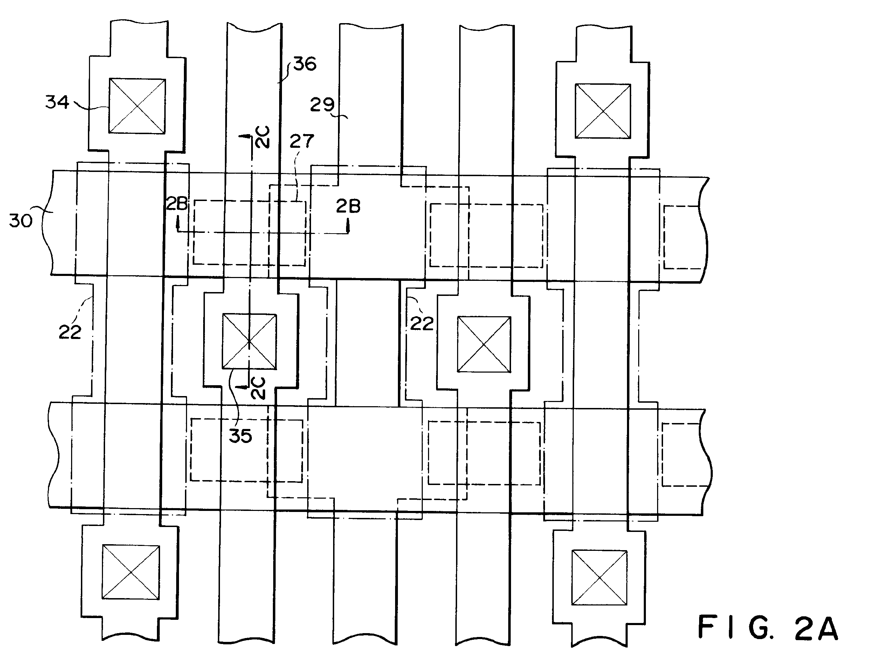

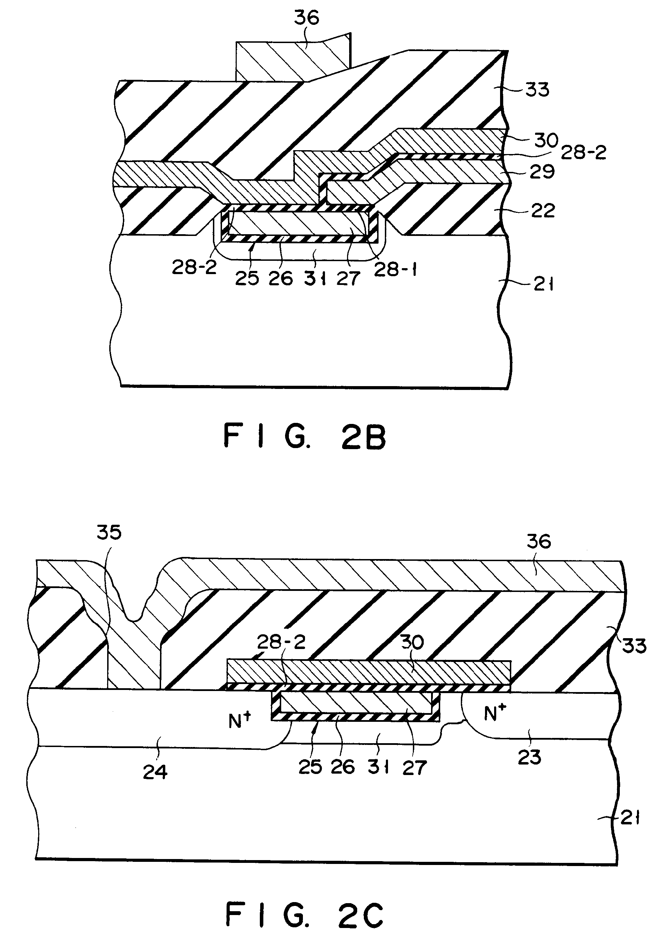

Figs. 2A to 2C are presented for explaining an FE²PROM according to the first embodiment of the present invention. Fig. 2A, which illustrates part of a memory cell array extracted, is a pattern plan view of memory cell transistors arranged in matrix form. Fig. 2B is a cross sectional view in a direction horizontal and normal to a channel direction of the memory cell transistor, i.e., along the line 2B-2B of the pattern shown in Fig. 2A. Fig. 2C is a cross sectional view along the channel direction of the memory cell transistor, i.e., along the line 2C-2C of the pattern shown in Fig. 2A.

A field insulating film 22 as an element isolating region of a memory cell is selectively formed on the major surface of a semiconductor substrate 21 made of P type silicon. N⁺ source and drain regions 23 and 24 are formed away from each other at a given interval in an element region on the major surface region of the substrate 21. A groove 25 is formed in the substrate 21 between the source and drain regions 23 and 24. An insulating film 26 is formed on the side wall portion and bottom portion of the groove 25. A floating gate 27 made of polysilicon is formed in the groove 25, filled up to the major surface of the substrate 21. Ions, such as Boron ions (B⁺), are implanted in the substrate 21 around the groove 25 between the source and drain regions 23 and 24 to thereby form a P type impurity diffusion region 31 for optimizing the impurity density of a channel region. A thin insulating film 28-1 is formed on part of the floating gate 27, and an insulating film 28-2 is formed on the other region thereof. The insulating film 28-1 is formed in a region with a size of approximately 1/3 of the gate length of the floating gate 27, whereas the insulating film 28-2 is formed in a region with a size of approximately 2/3 of this gate length. An erase gate 29 made of polysilicon is formed on the insulating film 28-1, and the insulating film 28-2 is formed on the surface of the erase gate 29. A control gate 30 made of polysilicon is formed on the insulating film 28-2 on the floating gate 27 and erase gate 29.

An interlayer insulating film 33 is formed on the resultant structure. A source contact hole 34 is formed in the interlayer insulating film 33 on the source region 23, and a drain contact hole 35 in the film 33 on the drain region 24. Although not illustrated, contact holes are formed on part of the erase gate 29 and part of the control gate 30. Metal wiring layers of aluminum or the like are formed in the individual contact holes and on the interlayer insulating film 33. Figs. 2A to 2C illustrate a drain wiring layer 36 as a representative one of these metal wiring layers. A voltage for programming, a readout voltage and an erase voltage are selectively applied through these metal wiring layers to the source and drain regions 23 and 24 and individual gates 29 and 30 in accordance with the respective operation modes.

With the above structure, as the floating gate 27 is formed in the groove 25, what lies on the filed insulating film 22 is a double-layered polysilicon layer consisting of the erase gate 29 and control gate 30. As a result, the surface step of the interlayer insulating film 33 can be made smaller compared with the structure shown in Figs. 1A and 1B, thus making it possible to prevent the metal wiring layer formed on the insulating film 33 (e.g., drain wiring layer 36) from being cut at the step portion.

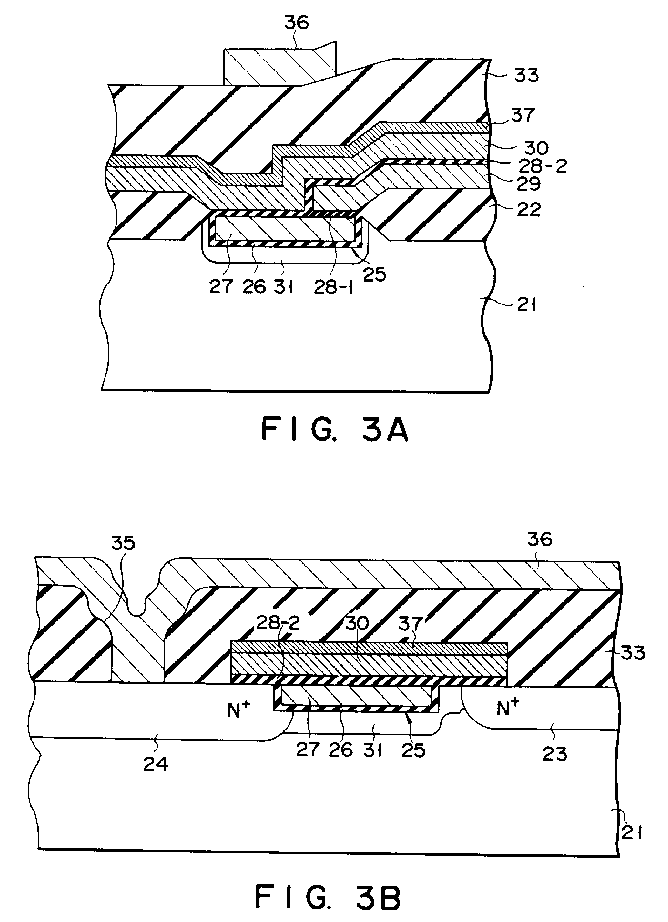

If a layer 37 of high melting point metal, such as molybdenum or tungsten, is formed on the control gate 30 as shown in Figs. 3A and 3B to reduce the resistance of the gate 30, the step between that region of the control gate 30 which lies on the erase gate 29 and that region of the gate 30 which lies on the floating gate 27 becomes smaller because the floating gate 27 is formed in the groove 25. Therefore, this structure can prevent cutting of the high melting point metal layer 37 at the step portion as well as cutting of the metal wiring layer 36.

Accordingly, the present invention can provide a semiconductor memory device which can prevent metal wiring layer 36 and the high melting point metal layer 37 from being cut at the step portion and has an improved reliability.

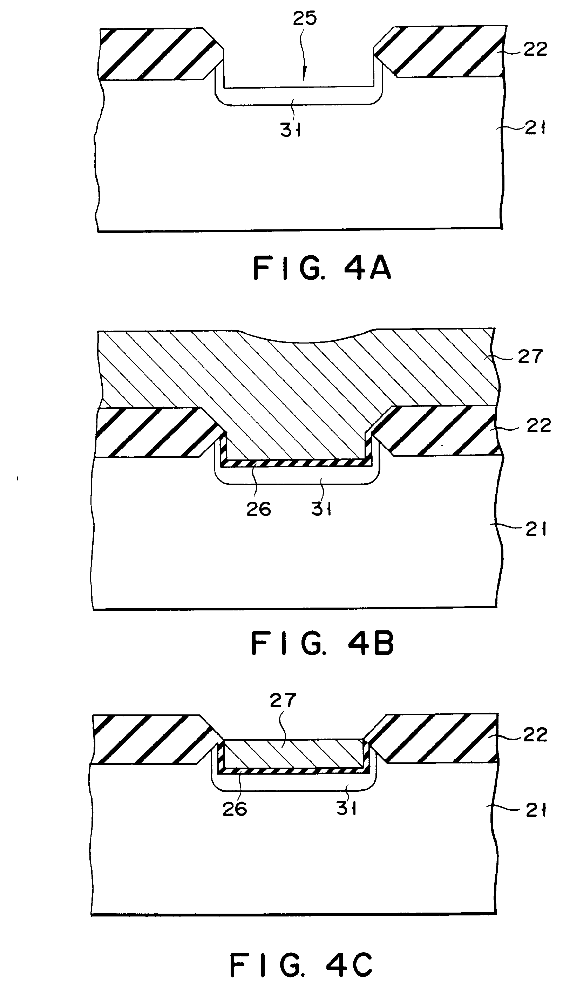

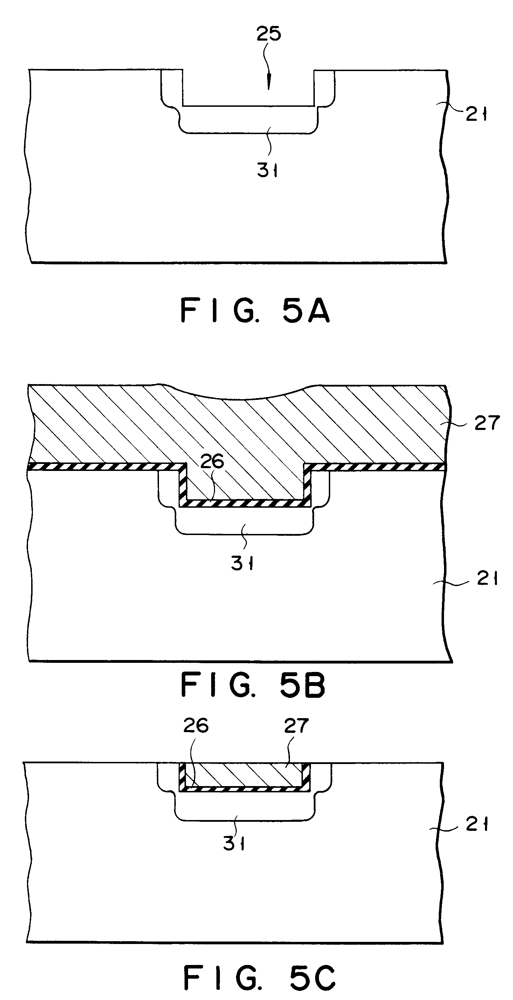

A method of fabricating the FE²PROM shown in Figs. 2A to 2C will be described below referring to Figs. 4A to 4E and 5A to 5E. Figs. 4A to 4E are cross sectional views illustrating the cross sections of the pattern shown in Fig. 2A taken along the line 2B-2B in the order of the fabrication steps, and Figs. 5A to 5E are cross sectional views illustrating the cross sections of the pattern in Fig. 2A taken along the line 2C-2C in the order of the fabrication steps.

First, the field insulating film 22 is selectively formed on the major surface of the P type silicon substrate 21, as shown in Figs. 4A and 5A, by the LOCOS method, for example. The groove 25 is formed in the element region on the major surface of the substrate 21 by the RIE (Reactive Ion Etching) method. Boron ions (B⁺), for example, are implanted in the bottom and side wall portion of the groove 25 in order to set the impurity density of a channel region, thereby forming the impurity diffusion region 31. At the time of the ion implantation, an ion beam is irradiated on the major surface of the substrate 21 a plurality of times at different angles, so that the boron ions are also implanted in the side wall portion of the groove 25. Although the impurity diffusion region 31 is formed at the bottom and both side wall portions of the groove 25 in Fig. 5A, it may be formed on the bottom of the groove 25 and that side wall portion thereof on which side the source region is expected to be formed.

Subsequently, the exposed surface of the substrate 21 is subjected to thermal oxidization, forming the first insulating film 26 on the element region on the substrate 21 and the bottom and side wall portion of the groove 25. The polysilicon layer 27 thick enough to flatten the surface of the resultant structure, e.g., 5.5 »m thick, is deposited on the resultant structure (see Figs. 4B and 5B).

This polysilicon layer 27 is etched back to the main surface of the substrate 21 by the RIE method, thus forming the floating gate 27 filled up to the groove 25. At this time, the insulating film 26 formed on the major surface of the substrate 21 is also removed, thus providing the structure as shown in Figs. 4C and 5C.

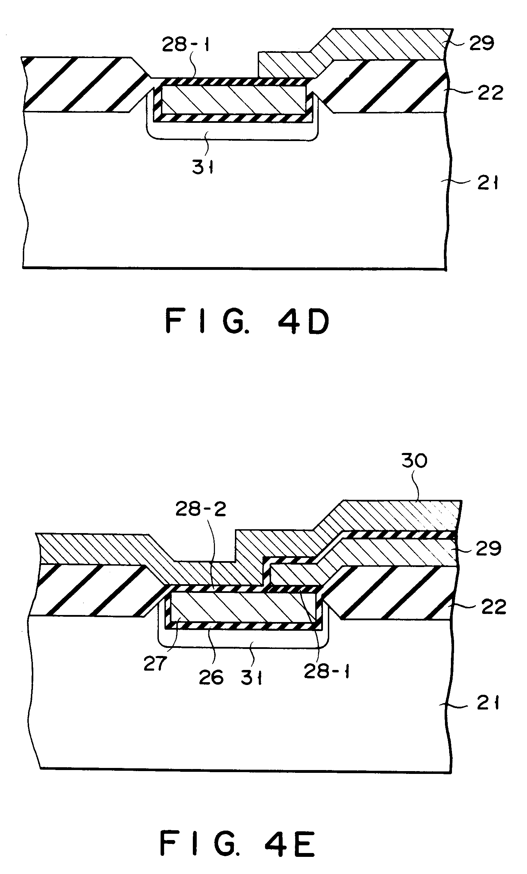

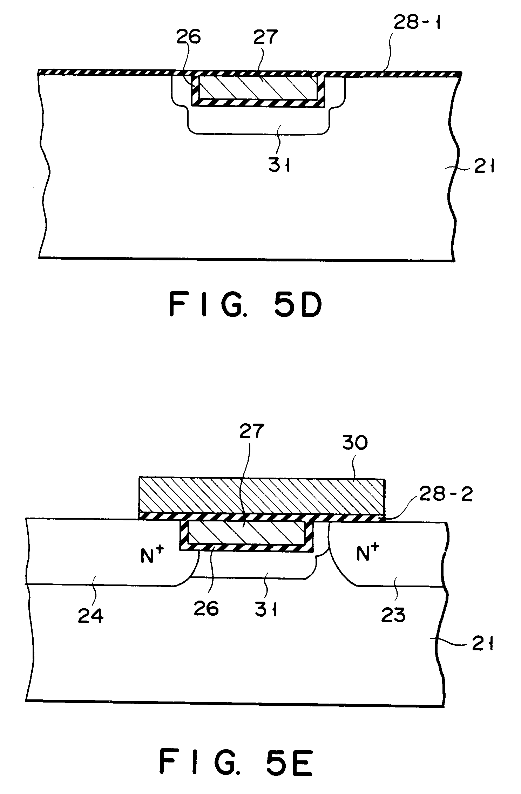

The surface of the floating gate 27 is subjected to thermal oxidization to form the second insulating film 28-1, as shown in Figs. 4D and 5D. A polysilicon layer is deposited on this insulating film 28-1 and on part of the field insulating film 22. This polysilicon layer is patterned by photolithography to thereby form the erase gate 29, which faces a region with a size of 1/3 of the gate length of the floating gate 27 through the second insulating film 28-1.

Then, the surface of the erase gate 29 is subjected to thermal oxidization to form the third insulating film 28-2. At this time, the oxidized film 28-1 on the floating gate 27 becomes thicker to be the insulating film 28-2. A polysilicon layer is deposited on the resultant structure, and is patterned by photolithography to form the control gate 30. With the gates 27, 29 and 30 used as masks, an impurity is ion-implanted in the major surface region of the substrate 21 to form the N⁺ source and drain regions 23 and 24. The resultant structure is illustrated in Figs. 4E and 5E.

Subsequently, the interlayer insulating film 33 is deposited on the resultant structure, and the source contact hole 34 is formed in that region of the interlayer insulating film 33 which lies on the source region 23 and the drain contact hole 35 in that region of the interlayer insulating film 33 which lies on the drain region 24. Contact holes are formed in part of the erase gate 29 and part of control gate 30. Metal wiring layers are formed in the contact holes and on the interlayer insulating film 33.

With this method in use, since the floating gate 27 is formed in the groove 25, what lies on the field insulating film 22 is a double-layered polysilicon layer consisting of the erase gate 29 and control gate 30. The surface step of the interlayer insulating film 33 can therefore be reduced. Accordingly, the present method can facilitate processing of the metal wiring layers.

In forming the layer 37 of high melting point metal, such as molybdenum or tungsten, on the control gate 30 as shown in Figs. 3A and 3B, a polysilicon layer which is to be the control gate 30 is deposited, then the metal layer 37 of high melting point metal, such as molybdenum or tungsten, is vapor-deposited on this polysilicon layer, and this metal layer 37 is patterned by photolithography in the step illustrated in Figs. 4E and 5E. The subsequent steps are the same as those described above. This method can reduce the step between that region of the control gate 30 which lies on the erase gate 29 and that region of the gate 30 which lies on the floating gate 27, thus facilitating the processing of the high melting point metal layer 37.

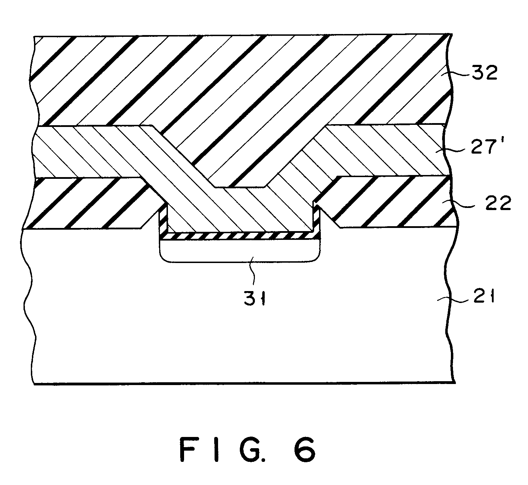

According to the above-described method, the polysilicon layer 27 with a thickness of 5.5 »m sufficient for surface flattening is deposited and this layer 27 is etched back to the main surface of the substrate 21 by the RIE method in the step shown in Figs. 4B and 5B. As shown in Fig. 6, however, the floating gate 27 may be formed in the groove 25 by coating a photoresist 32 on a thin polysilicon layer 27′, then etching the photoresist 32 and the polysilicon layer 27′. This will be described below more specifically. The polysilicon layer 27′ with a thickness of 0.5 »m is formed on the semiconductor structure shown in Figs. 4A and 5A, and the resist 32 thick enough to flatten the surface (e.g., 6 »m thick) is coated on the polysilicon layer 27′. The RIE is then conducted under the conditions to make the etching rate of the resist 32 equal to that of the polysilicon layer 27′, so that they are etched back to the major surface of the substrate 21. As a result, the floating gate 27 is formed in the groove 25 as shown in Figs. 4C and 5C. The subsequent steps are the same as those illustrated in Figs. 4C to 4E and 5C to 5E.

This second method can also produce the same effect as the first method.

Reference signs in the claims are intended for better understanding and shall not limit the scope.

## Claims

1. A semiconductor memory device having a stacked structure of a floating gate, a control gate and an erase gate, for storing data based on whether or not electrons are accumulated in said floating gate and erasing stored data using said erase gate, said memory device comprising a semiconductor substrate (21) of a first conductivity type, a field insulating film (22) selectively formed on a major surface of said semiconductor substrate (21), a source region (23) and a drain region (24) of a second conductivity type, formed in an element region on a major surface region of said semiconductor substrate (21), separated from each other at a predetermined interval, a groove (25) formed in said major surface of said semiconductor substrate (21) between said source region (23) and said drain region (24), a first insulating film (26) formed on a surface of said semiconductor substrate (21) at bottom and side wall portions of said groove (25), a floating gate (27) formed in said groove (25) and filling up said groove such that it does not extend beyond said groove, a thin second insulating film (28-1) formed on part of a surface of said floating gate (27), an erase gate (29) formed on said second insulating film (28-1) and part of said field insulating film (22), a third insulating film (28-2) formed on a surface of said erase gate (29) and the other part of said floating gate (27), and a control gate (30) formed on said third insulating film (28-2).

2. The semiconductor memory device according to claim 1, characterized in that said semiconductor substrate (21) includes a silicon substrate (11).

3. The semiconductor memory device according to claim 1, characterized in that said first to third insulating films (26, 28-1, 28-2) each include a silicon oxide film.

4. The semiconductor memory device according to claim 1, characterized in that said floating gate (27), said erase gate (29) and said control gate (30) are each made of polysilicon.

5. The semiconductor memory device according to claim 1, characterized by further comprising a high melting point metal layer (37) formed on said control gate (30).

6. The semiconductor memory device according to claim 5, characterized in that a material of said high melting point metal layer (37) is selected from a group including molybdenum and tungsten.

7. The semiconductor memory device according to claim 1, characterized by further comprising an impurity diffusion region (31) of said first conductivity type, formed in said semiconductor substrate (21) at bottom and side wall portions of said groove (25), for setting the impurity density of a channel region.

8. The semiconductor memory device according to claim 1, characterized by further comprising an interlayer insulating film (33) formed on said control gate (30), and a metal wiring layer (34, 35) formed on said interlayer insulating film (33) and electrically connected to one of said source region (23), said drain region (24), said erase gate (29) and said control gate (30).

9. A method of fabricating a semiconductor memory device according to any of the preceding claims having a stacked structure of a floating gate, a control gate and an erase gate, for storing data based on whether or not electrons are accumulated in said floating gate and erasing stored data using said erase gate, said method comprising the steps of selectively forming a field insulating film (22) for element isolation on a major surface of a semiconductor substrate (21), forming a groove (25) in an element region on said major surface of said semiconductor substrate (21), forming a first insulating film (26) on bottom and side wall portions of said groove (25), forming a floating gate (27) in said groove (25), forming a thin second insulating film (28-1) on a surface of said floating gate (27), forming an erase gate (29) on said second insulating film (28-1) on part of said floating gate (27) and part of said field insulating film (22), forming a third insulating film (28-2) on a surface of said erase gate (29) and the other part of said floating gate (27), forming a control gate (30) on said third insulating film (28-2), and forming a source region (23) and a drain region (24) in a major surface region of said semiconductor substrate (21) on both sides of said groove (25).

10. The method according to claim 9, characterized in that said field insulating film (22) is formed by a LOCOS method.

11. The method according to claim 9, characterized in that said groove (25) is formed by removing said major surface of said semiconductor substrate (21) by an RIE method.

12. The method according to claim 9, characterized in that said first insulating film (26) is formed through thermal oxidization of said surface of said semiconductor substrate (21) at bottom and side wall portions of said groove (25).

13. The method according to claim 9, characterized in that said floating gate (27) is a remainder of a thick polysilicon layer in said groove (25) after being formed in said groove (25) and on said field insulating film (22), then etched back.

14. The method according to claim 9, characterized in that said floating gate (27) is a remainder of a polysilicon layer (27′) in said groove (25) after said polysilicon layer (27′) is formed in said groove (25) and on said field insulating film (22), a photoresist (32) is coated on said polysilicon layer (27′), then said polysilicon (27′) and said photoresist (32) are etched back at a same etching rate.

15. The method according to claim 9, characterized in that said second insulating film (28-1) is formed by subjecting the surface of said floating gate (27) to thermal oxidization.

16. The method according to claim 9, characterized in that said erase gate (29) overlaps a region with a size of 1/3 of a gate length of said floating gate (27) through said second insulating film (28-1).

17. The method according to claim 9, characterized in that said third insulating film (28-2) is formed by subjecting the surface of said floating gate (27) and the surface of said erase gate (29) to thermal oxidization.

18. The method according to claim 9, characterized in that said control gate (30) is formed by patterning a polysilicon layer.

19. The method according to claim 9, characterized by further comprising a step of forming a high melting point metal layer (37) on said control gate (30).

20. The method according to claim 9, characterized in that a material of said high melting point metal layer (37) is selected from a group including molybdenum and tungsten.

21. The method according to claim 9, characterized by further comprising a step of forming an impurity diffusion region (31) of said first conductivity type in said semiconductor substrate (21) at bottom and side wall portions of said groove (25), for setting an impurity density of a channel region, after said groove forming step.

22. The method according to claim 9, characterized by further comprising the steps of forming an interlayer insulating film (33) formed on said control gate (30) after said step of forming said source region (23) and said drain region (24), forming a contact hole (34, 35) on at least one of those regions of said interlayer insulating film (33) which lie on said source region (23), on said drain region (24), on said erase gate (29) and on said control gate (30), and forming a metal wiring layer (36) on part of said interlayer insulating film and in said contact hole (34, 35).

## Patentansprüche

1. Halbleiterspeichereinrichtung mit einer geschichteten Struktur aus einem schwebenden Gate, einen Steuer-Gate und einem Löschungs-Gate, zur Speicherung von Daten auf der Grundlage, ob Elektronen in dem schwebenden Gate akkumuliert sind oder nicht, und zum Löschen von gespeicherten Daten unter Verwendung des Löschungs-Gates, wobei die Speichereinrichtung umfaßt: ein Halbleitersubstrat (21) eines ersten Leitfähigkeitstyps, einen Feldisolationsfilm (22), der selektiv auf einer Hauptoberfläche des Halbleitersubstrats (21) gebildet ist, einen Source-Bereich (23) und einen Drain-Bereich (24) eines zweiten Leitfähigkeitstyps, die in einem Elementbereich auf einem Hauptoberflächenbereich des Halbleitersubstrats (21) gebildet sind und zueinander in einem vorgegebenen Abstand liegen, eine Ausnehmung (25), die in der Hauptoberfläche des Halbleitersubstrats (21) zwischen dem Source-Bereich (23) und dem Drain-Bereich (24) gebildet ist, ein erster Isolationsfilm (26), der auf einer Oberfläche des Halbleitersubstrats (21) an Boden- und Seitenwandabschnitten der Ausnehmung (25) gebildet ist, ein schwebenden Gate (27), welches in der Ausnehmung (25) gebildet ist und die Ausnehmung so auffüllt, daß es sich nicht über die Ausnehmung hinaus erstreckt, ein dünner zweiter Isolationsfilm (28-1), der auf einem Teil einer Oberfläche des schwebenden Gates (27) gebildet ist, ein Löschungs-Gate (29), welches auf dem zweiten Isolationsfilm (28-1) und einem Teil des Feldisolationsfilms (22) gebildet ist, ein dritter Isolationsfilm (28-2), der auf einer Oberfläche des Löschungs-Gates (29) und dem anderen Teil des schwebenden Gates (27) gebildet ist, und ein Steuer-Gate (30), welches auf dem dritten Isolationsfilm (28-2) gebildet ist.

2. Speichereinrichtung nach Anspruch 1,
**dadurch gekennzeichnet, daß**
das Halbleitersubstrat (21) ein Siliziumsubstrat (11) umfaßt.

3. Halbleiterspeichereinrichtung nach Anspruch 1,
**dadurch gekennzeichnet, daß**
die ersten bis dritten Isolationsfilme (26,28-1,28-2) jeweils einen Siliziumoxidfilm umfassen.

4. Halbleiterspeichereinrichtung nach Anspruch 1,
**dadurch gekennzeichnet, daß**
das schwebende Gate (27), das Löschungs-Gate (29) und das Steuer-Gate (30) jeweils aus Polysilizium hergestellt sind.

5. Halbleiterspeichereinrichtung nach Anspruch 1,
**dadurch gekennzeichnet, daß**
sie ferner eine auf dem Steuer-Gate (30) gebildete Metallschicht (37) mit hohem Schmelzpunkt umfaßt.

6. Halbleiterspeichereinrichtung nach Anspruch 5,
**dadurch gekennzeichnet, daß**
ein Material der Metallschicht (37) mit hohem Schmelzpunkt aus einer Gruppe umfassend Molybden und Wolfram gewählt ist.

7. Halbleiterspeichereinrichtung nach Anspruch 1,
**dadurch gekennzeichnet, daß**
sie ferner einen in dem Halbleitersubstrat (21) an Boden- und Seitenwandabschnitten der Ausnehmung (25) gebildeten Verunreinigungs-Diffusionsbereich (31) des ersten Leitfähigkeitstyps umfaßt, um die Verunreinigungsdichte eines Kanalbereichs einzustellen.

8. Halbleiterspeichereinrichtung nach Anspruch 1,
**dadurch gekennzeichnet, daß**
sie ferner umfaßt: einen Zwischenschicht-Isolationsfilm (33) der auf dem Steuer-Gate (30) gebildet ist, und eine Metallverdrahtungsschicht (34,35), die auf dem Zwischenschicht-Isolationsfilm (33) gebildet und mit dem Source-Bereich (23), dem Drain-Bereich (24), dem Löschungs-Gate (29) oder dem Steuer-Gate (30) verbunden ist.

9. Verfahren zur Herstellung einer Halbleiterspeichereinrichtung nach irgendeinem der vorangehenden Ansprüche mit einer aufgeschichteten Struktur eines schwebenden Gates, eines Steuer-Gates und eines Löschungs-Gates, zur Speicherung von Daten auf der Grundlage, ob Elektronen in dem schwebenden Gate gespeichert sind oder nicht, und zum Löschen von gespeicherten Daten unter Verwendung des Löschungs-Gates, wobei das Verfahren die folgenden Schritte umfaßt: selektives Bilden eines Feldisolationsfilms (22) zur Elementisolation auf einer Hauptoberfläche des Halbleitersubstrats (21), Bilden einer Ausnehmung (25) in einem Elementbereich auf der Hauptoberfläche des Halbleitersubstrats (21), Bilden eines ersten Isolationsfilms (26) auf Boden- und Seitenwandabschnitten der Ausnehmung (25), Bilden eines schwebenden Gates (27) in der Ausnehmung (25), Bilden eines dünnen zweiten Isolationsfilms (28-1) auf einer Oberfläche des schwebenden Gates (27), Bilden eines Löschungs-Gates (29) auf dem zweiten Isolationsfilm (28-1) auf einem Teil des schwebenden Gates (27) und einem Teil des Feldisolationsfilms (22), Bilden eines dritten Isolationsfilms (28-2) auf einer Oberfläche des Löschungs-Gates (29) und dem anderen Teil des schwebenden Gates (27), Bilden eines Steuer-Gates (30) auf dem dritten Isolationsfilm (28-2) und Bilden eines Source-Bereichs (23) und eines Drain-Bereichs (24) in einem Hauptoberflächenbereich des Halbleitersubstrats (21) auf beiden Seiten der Ausnehmung (25).

10. Verfahren nach Anspruch 9,
**dadurch gekennzeichnet, daß**
der Feldisolationsfilm (22) durch ein LOCOS-Verfahren gebildet wird.

11. Verfahren nach Anspruch 9,
**dadurch gekennzeichnet, daß**
die Ausnehmung (25) durch Entfernung der Hauptoberfläche des Halbleitersubstrats (21) durch ein RIE-Verfahren gebildet wird.

12. Verfahren nach Anspruch 9,
**dadurch gekennzeichnet, daß**
der erste Isolationsfilm (26) durch thermische Oxidation der Oberfläche des Halbleitersubstrats (21) an Boden- und Seitenwandabschnitten der Ausnehmung (25) gebildet wird.

13. Verfahren nach Anspruch 9,
**dadurch gekennzeichnet, daß**
das schwebende Gate (27) ein Rest einer dicken polysiliziumschicht in der Ausnehmung (25) ist, nachdem diese in der Ausnehmung (25) und auf dem Feldisolationsfilm (22) gebildet und dann zurückgeätzt wird.

14. Verfahren nach Anspruch 9,
**dadurch gekennzeichnet, daß**
das schwebende Gate (27) ein Rest einer polysiliziumschicht (27′) in der Ausnehmung (25) ist, nachdem die polysiliziumschicht (27′) in der Ausnehmung (25) und auf dem Feldisolationsfilm (22) gebildet ist, ein Photolack (32) auf die Polysiliziumschicht (27′) aufgebracht wird und dann das polysilizium (27′) und der Photolack (32) bei der gleichen Ätzrate zurückgeätzt werden.

15. Verfahren nach Anspruch 9,
**dadurch gekennzeichnet, daß**
der zweite Isolationsfilm (28-1) gebildet wird, indem die Oberfläche des schwebenden Gates (27) einer thermischen Oxidation ausgesetzt wird.

16. Verfahren nach Anspruch 9,
**dadurch gekennzeichnet, daß**
Löschungs-Gate (29) einen Bereich mit einer Größe von 1/3 einer Gate-Länge des schwebenen Gates (27) durch den zweiten Isolationsfilm (28-1) überlappt.

17. Verfahren nach Anspruch 9,
**dadurch gekennzeichnet, daß**
der dritte Isolationsfilm (28-2) gebildet wird, indem die Oberfläche des schwebenden Gates (27) und die Oberfläche des Löschungs-Gates (29) einer thermischen Oxidation ausgesetzt werden.

18. Verfahren nach Anspruch 9,
**dadurch gekennzeichnet, daß**
Steuer-Gate (30) durch Strukturierung einer Polysiliziumschicht gebildet wird.

19. Verfahren nach Anspruch 9,
**dadurch gekennzeichnet, daß**
es ferner einen Schritt zur Bildung einer Metallschicht (37) mit hohem Schmelzpunkt auf dem Steuer-Gate (30) umfaßt.

20. Verfahren nach Anspruch 9,
**dadurch gekennzeichnet, daß**
ein Material der Metallschicht (37) mit hohem Schmelzpunkt aus einer Gruppe umfassend Molybden und Wolfram gewählt ist.

21. Verfahren nach Anspruch 9,
**dadurch gekennzeichnet, daß**
es ferner eine Schritt umfaßt, in dem ein Verunreinigungsdiffusionsbereich (31) des ersten Leitfähigkeitstyps in dem Halbleitersubstrat (21) an Boden- und Seitenwandabschnitten der Ausnehmung (25) gebildet wird, um eine Verunreinigungsdichte eines Kanalbereichs einzustellen, nach dem Schritt zur Bildung der Ausnehmung.

22. Verfahren nach Anspruch 9,
**dadurch gekennzeichnet, daß**
es ferner die folgenden Schritte umfaßt: Bilden eines Zwischenschicht-Isoltionsfilms (33), der auf dem Steuer-Gate (30) gebildet ist, nach dem Schritt einer Bildung des Source-Bereichs (23) und des Drain-Bereichs (24), Bilden eines Kontaktlochs (34,35) auf wenigstens einem Bereich von denjenigen Bereichen des Zwischenschicht-Isolationsfilms (33), die auf dem Source-Bereich (23), auf dem Drain-Bereich (24), auf dem Löschungs-Gate (29) und dem Steuer-Gate (30) liegen, und Bilden einer Metallverdrahtungsschicht (36) auf einem Teil des Zwischenschicht-Isolationsfilms und in dem Kontaktloch (34,35).

## Revendications

1. Un dispositif de mémoire semi-conducteur ayant une structure empilée d'une grille flottante, une grille de commande et une grille d'effacement, pour emmagasiner des données, selon que oui ou non des électrons sont accumulés dans ladite grille flottante, et effacer des données emmagasinées en utilisant ladite grille d'effacement, ledit dispositif de mémoire comprenant un substrat (21) de semi-conducteur d'un premier type de conductivité, un film (22) d'isolation de champ, formé sélectivement sur une surface principale dudit substrat (21) de semi-conducteur, une région (23) de source et une région (24) de drain d'un second type de conductivité, formées dans une région d'élément, sur une région de surface principale dudit substrat (21) de semi-conducteur, séparées l'une de l'autre à un intervalle prédéterminé, une rainure (25) formée dans ladite surface principale dudit substrat (21) de semi-conducteur, entre ladite région (23) de source et ladite région (24) de drain, un premier film (26) isolant formé sur une surface dudit substrat (21) de semi-conducteur, à des portions de fond et de paroi latérale de ladite rainure (25), une grille (27) flottante formée dans ladite rainure (25), et comblant ladite rainure de telle sorte, qu'elle ne s'étend pas au-delà de ladite rainure, un second film (28-1) isolant, mince, formé sur une partie d'une surface de ladite grille (27) flottante, une grille (29) d'effacement formée sur ledit second film (28-1) isolant et une partie dudit film (22) d'isolation de champ, un troisième film (28-2) isolant formé sur une surface de ladite grille (28) d'effacement et l'autre partie de ladite grille (27) flottante, et une grille (30) de commande formée sur ledit troisième film (28-2) isolant.

2. Le dispositif de mémoire semi-conducteur selon la revendication 1, caractérisé en ce que ledit substrat (21) de semi-conducteur inclut un substrat (11) de silicium.

3. Le dispositif de mémoire semi-conducteur selon la revendication 1, caractérisé en ce que lesdits premier à troisième films (26, 28-1, 28-2) isolants incluent chacun un film d'oxyde de silicium.

4. Le dispositif de mémoire semi-conducteur selon la revendication 1, caractérisé en ce que ladite grille (27) flottante, ladite grille (29) d'effacement et ladite grille (30) de commande sont faites chacune de polysilicium.

5. Le dispositif de mémoire semi-conducteur selon la revendication 1, caractérisé en ce qu'il comprend de plus une couche (37) de métal à point de fusion élevé, formée sur ladite grille (30) de commande.

6. Le dispositif de mémoire semi-conducteur selon la revendication 5, caractérisé en ce qu'une matière de ladite couche (37) de métal à point de fusion élevé est sélectionnée à partir d'un groupe incluant le molybdène et le tungstène.

7. Le dispositif de mémoire semi-conducteur selon la revendication 1, caractérisé en ce qu'il comprend de plus une région (31) de diffusion d'impureté dudit premier type de conductivité, formée dans ledit substrat (21) de semiconducteur, à des portions de fond et de paroi latérale de ladite rainure (25), pour établir la densité d'impureté d'une région de canal.

8. Le dispositif de mémoire semi-conducteur selon la revendication 1, caractérisé en ce qu'il comprend de plus un film (33) d'isolation d'intercouche, formé sur ladite grille (30) de commande, et une couche (34, 35) de conducteur électrique métallique, formée sur ledit film (33) d'isolation d'intercouche et reliée électriquement à l'une de ladite région (23) de source, ladite région (24) de drain, ladite grille (29) d'effacement et ladite grille (30) de commande.

9. Un procédé de fabrication d'un dispositif de mémoire semi-conducteur selon une quelconque des précédentes revendications, ayant une structure empilée d'une grille flottante, une grille de commande et une grille d'effacement, pour emmagasiner des données, selon que oui ou non des électrons sont accumulés dans ladite grille flottante, et effacer des données emmagasinées en utilisant ladite grille d'effacement, ledit procédé comprenant les étapes de : formation sélective d'un film (22) d'isolation de champ, pour isolation d'élément sur une surface principale d'un substrat (21) de semi-conducteur, formation d'une rainure (25) dans une région d'élément, sur ladite surface principale dudit substrat (21) de semi-conducteur, formation d'un premier film (26) isolant sur des portions de fond et de paroi latérale de ladite rainure (25), formation d'une grille (27) flottante dans ladite rainure (25), formation d'un second film (28-1) isolant, mince, sur une surface de ladite grille (27) flottante, formation d'une grille (29) d'effacement sur ledite second film (28-1) isolant, sur une partie de ladite grille (27) flottante et une partie dudit film (22) d'isolation de champ, formation d'un troisième film (28-2) isolant, sur une surface de ladite grille (29) d'effacement et l'autre partie de ladite grille (27) flottante, formation d'une grille (30) de commande, sur ledit troisième film (28-2) isolant, et formation d'une région (23) de source et d'une région (24) de drain, dans une région de surface principale dudit substrat (21) de semi-conducteur, sur les deux côtés de ladite rainure (25).

10. Le procédé selon la revendication 9, caractérisé en ce que ledit film (22) d'isolation de champ est formé par un procédé LOCOS.

11. Le procédé selon la revendication 9, caractérisé en ce que ladite rainure (25) est formée par retrait de ladite surface principale dudit substrat (21) de semi-conducteur, par un procédé RIE.

12. Le procédé selon la revendication 9, caractérisé en ce que ledit premier film (26) isolant est formé par oxydation thermique de ladite surface dudit substrat (21) de semi-conducteur, à des portions de fond et de paroi latérale de ladite rainure (25).

13. Le procédé selon la revendication 9, caractérisé en ce que ladite grille (27) flottante est un reste d'une couche de polysilicium épaisse dans ladite rainure (25), après qu'elle ait été formée dans ladite rainure (25) et sur ledit film (22) d'isolation de champ, puis attaquée à l'arrière.

14. Le procédé selon la revendication 9, caractérisé en ce que ladite grille (27) flottante est un reste d'une couche (27′) de polysilicium dans ladite rainure (25), après que ladite couche (27′) de polysilicium ait été formée dans ladite rainure (25) et sur ledit film (22) d'isolation de champ, un photorésiste (32) ait été déposé par enduction sur ladite couche (27′) de polysilicium, puis que ladite couche (27′) de polysilicium et ledit photorésiste (32) ait été attaqué à l'arrière avec un même taux d'attaque.

15. Le procédé selon la revendication 9, caractérisé en ce que ledit second film (28-1) isolant est formé en soumettant la surface de ladite grille (27) flottante a une oxydation thermique.

16. Le procédé selon la revendication 9, caractérisé en ce que ladite grille (29) d'effacement chevauche une région ayant une dimension de 1/3 d'une longueur de grille de ladite grille (27) flottante, par l'intermédiaire dudit second film (28-1) isolant.

17. Le procédé selon la revendication 9, caractérisé en ce que ledit troisième film (28-2) isolant est formé en soumettant la surface de ladite grille (27) flottante et la surface de ladite grille (29) d'effacement a une oxydation thermique.

18. Le procédé selon la revendication 9, caractérisé en ce que ladite grille (30) de commande est formée en dessinant une couche de polysilicium.

19. Le procédé selon la revendication 9, caractérisé en ce qu'il comprend de plus une étape de formation d'une couche (37) de métal à point de fusion élevé sur ladite grille (30) de commande.

20. Le procédé selon la revendication 9, caractérisé en ce qu'une matière de ladite couche (37) de métal à point de fusion élevé est sélectionnée à partir d'un groupe incluant le molybdène et le tungstène.

21. Le procédé selon la revendication 9, caractérisé en ce qu'il comprend de plus une étape de formation d'une région (31) de diffusion d'impureté dudit premier type de conductivité, dans ledit substrat (21) de semi-conducteur, à des portions de fond et de paroi latérale de ladite rainure (25), pour établir une densité d'impureté d'une région de canal, après ladite étape de formation de rainure.

22. Le procédé selon la revendication 9, caractérisé en ce qu'il comprend de plus des étapes de formation d'un film (33) d'isolation d'intercouche, formé sur ladite grille (30) de commande après ladite étape de formation de ladite région (23) de source et de ladite région (24) de drain, formation d'un trou (34, 35) de contact, sur au moins une de ces régions dudit film (33) d'isolation d'intercouche, qui s'étend sur ladite région (23) de source, sur ladite région (24) de drain, sur ladite grille (29) d'effacement et sur ladite grille (30) de commande, et formation d'une couche (36) de conducteur électrique métallique, sur une partie dudit film d'isolation d'intercouche et dans ledit trou (34, 35) de contact.
